# EUROPEAN PATENT APPLICATION

(11) **EP 4 770 365 A2**
(43) Date of publication of application: **01.07.2026**
(21) Application number: 25217672.2
(22) Date of filing: 21.11.2025
(51) Int. Cl.: H10K 50/842, H10K 59/40

(54) **DISPLAY DEVICE**

(30) Priority: 30.12.2024 KR 20240200197
(71) Applicant: LG Display Co., Ltd., Seoul, 07336 (KR)
(72) Inventor: HONG, Yein, 10845 Paju-si, Gyeonggi-do (KR)
(74) Representative: Viering, Jentschura & Partner mbB Patent- und Rechtsanwälte

(57) **Abstract**

A display device (100) presented herein includes a substrate (110) including a display area (A/A) and a non-display area (N/A) surrounding the display area (A/A), a plurality of pixels (PX) disposed in the display area (A/A) and including a light emitting element (130) and a driving transistor (120), at least one dam (DAM1, DAM2, DAM3) disposed in the non-display area (N/A), an organic optical layer (141, 241) covering the plurality of pixels (PX), and at least one blocking pattern (CP1, CP2) disposed in the non-display area (N/A) and penetrating the organic optical layer (141, 241).

## Description

### BACKGROUND

### Field

The present disclosure relates to a display device, and more particularly to, for example, without limitation, a display device capable of improving reliability.

### Discussion of Related Art

Currently, as it enters the full-scale information era, the field of display devices that visually display electrical information signals is rapidly developing, and research is being conducted to develop various performances such as thinning, weight reduction, and low power consumption for display devices.

Representative display devices include a liquid crystal display (LCD), a field emission display (FED), an electro-wetting display (EWD), and an organic light emitting display (OLED).

In particular, a capping layer (CPL) may be disposed on an OLED. It is located on the CPL emission layer to improve luminous efficiency, protect the organic material layer from the external environment, and maintain charge balance. CPL improves luminous efficiency by reducing reflection of internal light, and protects sensitive layers from moisture and oxygen to enhance stability and durability.

The description provided in the discussion of the related art section should not be assumed to be prior art merely because it is mentioned in or associated with that section. The discussion of the related art section may include information that describes one or more aspects of the subject technology, and the description in this section does not limit the disclosure.

### SUMMARY

An object to be achieved by the present disclosure is to provide a display device which solves a problem caused by a moisture penetration path and a foreign material which may occur in an organic optical layer and an encapsulation layer, thereby extending a lifespan of a light emitting element and a driving transistor and reducing or preventing deterioration in device performance.

Another object to be achieved by the present disclosure is to provide a display device which maintains performance of a driving circuit and a light emitting element and optimizes power consumption by promoting uniformity of an electrical signal and stability of a voltage through a plurality of lines and a blocking pattern.

Objects of the present disclosure are not limited to the above-mentioned objects, and other objects, which are not mentioned above, can be clearly understood by those skilled in the art from the following descriptions. According to an aspect of the present disclosure, a display device according to claim 1 is provided. Further embodiments are described in the dependent claims.

A display device according to one or more embodiments of the present disclosure may include a substrate including a display area and a non-display area surrounding the display area, a plurality of pixels disposed in the display area and including a light emitting element and a driving transistor, at least one dam disposed in the non-display area, an organic optical layer covering the plurality of pixels, and at least one blocking pattern disposed in the non-display area and penetrating the organic optical layer.

A display device according to one or more other embodiments of the present disclosure may include a substrate including a display area and a non-display area surrounding the display area, a plurality of pixels disposed in the display area, a pixel of the plurality of pixels including a light emitting element, a data line disposed in the non-display area and including a metal material, the data line supplying a voltage to the pixel, at least one dam disposed in the non-display area, and at least one blocking pattern disposed in the non-display area and including a conductive material, wherein the at least one blocking pattern is directly connected to the data line.

Other detailed matters of the embodiments are included in the detailed description and the drawings.

According to the present disclosure, the penetration of external moisture and oxygen due to the organic optical layer is effectively blocked by the blocking pattern to suppress the degradation of the performance of the light emitting element and the driving transistor, and the durability of the display device can be improved.

The present disclosure promotes the stability of a voltage through an electrical connection between a plurality of lines and a blocking pattern, and suppresses electromagnetic interference (EMI) to maintain stable screen output and high definition.

The effects according to the present disclosure are not limited to the contents exemplified above, and more various effects are included in the present disclosure.

Other systems, methods, features and advantages will be, or will become, apparent to one with skill in the art upon examination of the following figures and detailed description. It is intended that all such additional systems, methods, features and advantages be included within this description, be within the scope of the present disclosure, and be protected by the following claims. Nothing in this section should be taken as a limitation on those claims. Further aspects and advantages are discussed below in conjunction with embodiments of the disclosure.

It is to be understood that both the foregoing general description and the following detailed description are exemplary and explanatory and are intended to provide further explanation of the inventive concepts as claimed.

### BRIEF DESCRIPTION OF THE DRAWINGS

The above and other aspects, features and other advantages of the present disclosure will be more clearly understood from the following detailed description taken in conjunction with the accompanying drawings.
FIG. 1 is a schematic plan view of a display device according to one or more embodiments of the present disclosure.
FIG. 2 is a schematic plan view of a display device according to one or more embodiments of the present disclosure.
FIG. 3 is a cross-sectional view of a display device taken along the line III-III' of FIG. 1.
FIG. 4 is a cross-sectional view of a display device taken along line IV-IV' illustrated in FIG. 1.
FIG. 5 is a cross-sectional view of a display device according to one or more other embodiments of the present disclosure.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION

Reference will now be made in detail to embodiments of the present disclosure, examples of which may be illustrated in the accompanying drawings. In the following description, when a detailed description of well-known functions or configurations related to this document is determined to unnecessarily obscure a gist of the inventive concept, the detailed description thereof will be omitted or may be briefly provided. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations may be selected only for convenience of writing the specification and may be thus different from those used in actual products.

Advantages and characteristics of the present disclosure and a method of achieving the advantages and characteristics will be clear by referring to embodiments described below in detail together with the accompanying drawings. However, the present disclosure is not limited to the embodiments disclosed herein but will be implemented in various forms. The embodiments are provided by way of example only so that those skilled in the art can fully understand the disclosures of the present disclosure and the scope of the present disclosure.

Throughout the drawings and the detailed description, unless otherwise described, the same drawing reference numerals should be understood to refer to the same elements, features, and structures. The relative size and depiction of these elements may be exaggerated for clarity, illustration, and convenience. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations are selected only for convenience of writing the specification and may be thus different from those used in actual products.

The shapes, sizes, ratios, angles, numbers, and the like illustrated in the accompanying drawings for describing the embodiments of the present disclosure are merely examples, and the present disclosure is not limited thereto. Further, in the following description of the present disclosure, a detailed explanation of known related technologies may be omitted or provided briefly to avoid unnecessarily obscuring the subject matter of the present disclosure. The terms such as "including," "having," and "comprising" used herein are generally intended to allow other components to be added unless the terms are used with the term "only". Any references to singular may include plural unless expressly stated otherwise.

Any implementation described herein as an "example" is not necessarily to be construed as preferred or advantageous over other implementations.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or layer or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the disclosure.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

The features of various embodiments in the present disclosure may be partially or wholly combined or associated with each other, various technical interlocking and operations are possible, and each embodiment may be implemented independently of each other or may be implemented together in an associated relationship.

It will be apparent to those skilled in the art that various modifications and variations can be made to the embodiments of the present disclosure without departing from the technical idea or scope of the present disclosure. Thus, it is intended that the present disclosure covers the modifications and variations of this disclosure provided they come within the scope of the appended claims and their equivalents.

Hereinafter, embodiments of the present disclosure will be described in detail with reference to accompanying drawings.

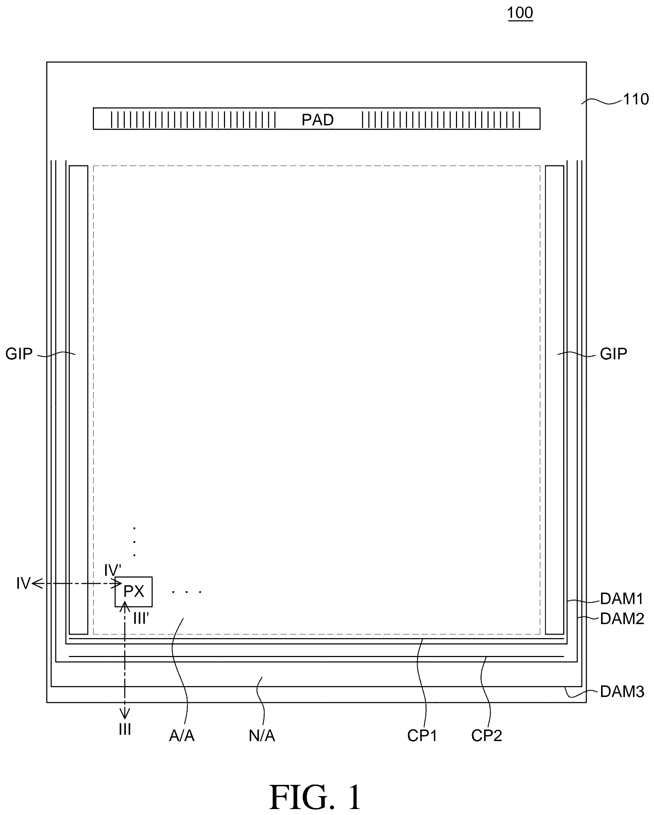

FIG. 1 is a schematic plan view of a display device according to one or more embodiments of the present disclosure. In FIG. 1, for the convenience of description, among various components of the display device 100, only a substrate 110, a pad PAD, a gate driving circuit GIP, a plurality of dams DAM1, DAM2, and DAM3, and a plurality of blocking patterns CP1 and CP2 are illustrated.

Referring to FIG. 1, a display device 100 includes at least one display area A/A, and an array of pixels PX is formed in the display area A/A. The non-display area N/A may be disposed to surround the display area A/A. That is, the non-display area N/A may be adjacent to one or more side surfaces of the display area A/A. In FIG. 1, the non-display area N/A surrounds the display area A/A having a rectangular shape. However, the shape of the display area A/A and the shape/arrangement of the non-display area N/A adjacent to the display area A/A are not limited to the example illustrated in FIG. 1.

Each pixel PX in the display area A/A may be related to a pixel circuit. The pixel circuit may include one or more switching transistors and one or more driving transistors on a backplane. Each pixel circuit may be electrically connected to the gate line and the data line to communicate with one or more driving circuits such as the gate driving circuit GIP and the data driving circuit located in the non-display area N/A. In addition, each pixel circuit may be connected to power supply lines located in the non-display area N/A to receive a voltage required for driving. As illustrated in FIG. 1, the gate driving circuit GIP may be implemented as a thin film transistor (TFT) in the non-display area N/A. The gate driving circuit may be referred to as a gate-in-panel (GIP). The gate driving circuit GIP may be disposed on at least one of the left and right sides of the display area A/A. In addition, some components, such as a data driver IC, are mounted on a separate printed circuit board and may be coupled to a plurality of pads PAD disposed in the non-display area N/A by using a circuit film such as a flexible printed circuit board (FPCB), chip-on-film (COF), tape carrier-package (TCP) and the like.

Further, the non-display area N/A may include a pad unit, and the pad unit may include a plurality of pads PAD. Specifically, the plurality of pads PAD may include a plurality of common power supply pads, a plurality of data input pads, a plurality of power supply pads, a plurality of control signal input pads, and a plurality of touch driving pads.

The display device 100 may further include various additional elements for generating various signals or driving the pixel PX in the display area A/A. The additional elements for driving the pixel PX may be an inverter circuit, a multiplexer, an electrostatic discharge circuit, or the like. The display device 100 may also include additional elements related to functions other than pixel driving. For example, the display device 100 may include additional elements that provide a touch sensing function, a user authentication function (e.g., fingerprint recognition), a multi-level pressure sensing function, a tactile feedback function, and the like. The above-mentioned additional elements may be located in an external circuit connected to the non-display area N/A and/or the connection interface.

The plurality of dams DAM1, DAM2, and DAM3 is disposed in the non-display area N/A to surround the display area A/A. The plurality of dams DAM1, DAM2, and DAM3 is disposed in an area excluding a side surface on which the pad PAD is disposed in the non-display area N/A. That is, the plurality of dams DAM1, DAM2, and DAM3 may be disposed at the outside of the gate driving circuit GIP, as well as disposed at the opposite side of the side on which the pad PAD is disposed. Accordingly, the plurality of dams DAM1, DAM2, and DAM3 serves to control the spread of the encapsulation layer in stages, and each of the dams DAM1, DAM2, and DAM3 serves to ensure that the encapsulation layer does not deviate from the limited boundary.

Specifically, the first dam DAM1 is located at the outer periphery of the display area A/A and serves as a first blocking role so that the encapsulation layer is limited only into the display area A/A. Further, the second dam DAM2 is located outside the first dam DAM1 and is disposed at a certain interval from the first dam DAM1. The second dam DAM2 reinforces the boundary formed by the first dam DAM1 and further blocks the encapsulation layer from being diffused over a wider range. The third dam DAM3 is disposed outside the second dam DAM2 to maintain a constant interval with the second dam DAM2. The third dam DAM3 serves as a final defense line, and limits diffusion of the encapsulation layer as much as possible. The dams DAM1, DAM2, and DAM3 reduce or minimize an influence from the external environment of the display device and ensure overall structural stability of the device.

The plurality of blocking patterns CP1 and CP2 is disposed between the plurality of dams DAM1, DAM2, and DAM3 to block the moisture penetration path in the corresponding area. By effectively blocking moisture permeation at this position, it contributes to protecting the internal components of the display device from moisture and improving overall durability.

Specifically, the plurality of blocking patterns CP1 and CP2 is disposed only on the opposite side to the side surface on which the pad PAD is disposed, but is not disposed outside the gate driving circuit GIP. Further, the first blocking pattern CP1 is positioned between the display area A/A and the first dam DAM1. Further, the second blocking pattern CP2 is positioned between the first dam DAM1 and the second dam DAM2.

At least one of the blocking patterns CP1 and CP2 extends in a plan view of the display device 100 from a first side of the display device 100 to a second side of the display device 100 opposite to the first side. A length of at least one of the blocking patterns CP1 and CP1 is greater than a width of the display area A/A in the plan view of the of the display device 100.

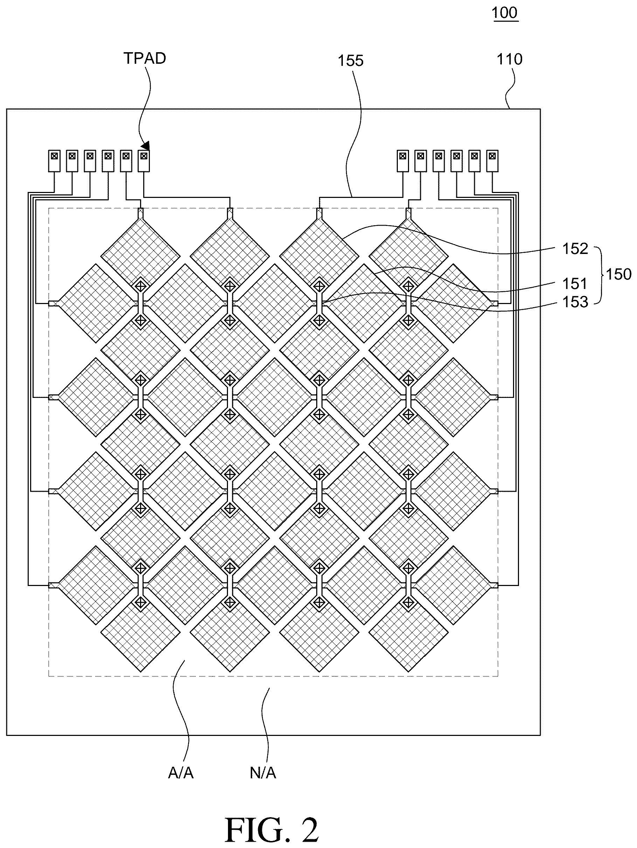

FIG. 2 is a schematic plan view of a display device according to one or more embodiments of the present disclosure. In FIG. 2, for the convenience of description, among various components of the display device 100, only a substrate 110, a touch sensing unit 150, a touch routing line 155, and a plurality of touch pads TPAD are illustrated.

Recently, in order to reduce the thickness of the display device and improve visibility, a touch panel integrated display device in which a touch electrode or the like is directly disposed on an encapsulation layer of the display device has been developed. The display device 100 according to one or more embodiments of the present disclosure is a touch panel integrated display device, and the touch sensing unit 150 may be formed on the encapsulation layer of the display device 100.

Referring to FIG. 2, the display device 100 includes a touch sensing unit 150, a plurality of touch routing lines 155, and a plurality of touch pads TPAD. Here, the touch sensing unit 150 includes a plurality of first touch electrodes 151, a plurality of second touch electrodes 152, and a touch connection electrode 153.

The plurality of first touch electrodes 151 may be touch driving electrodes, and the plurality of second touch electrodes 152 may be touch sensing electrodes. The plurality of first touch electrodes 151 may be connected in a row direction to form a plurality of electrode rows, and the plurality of second touch electrodes 152 may be connected in a longitudinal direction by the touch connection electrode 153 to form a plurality of electrode columns.

The first touch electrode 151 and the second touch electrode 152 may be disposed on the same layer. However, in an area where the first touch electrode 151 and the second touch electrode 152 intersect, the second touch electrode 152 may be disposed to be separated, and the separated second touch electrodes 152 may be connected by the touch connection electrode 153.

In this case, the first touch electrode 151, the second touch electrode 152, and the touch connection electrode 153 are disposed in an area corresponding to the display area A/A of the display device 100.

The outer shapes of the first touch electrode 151 and the second touch electrode 152 may correspond to specific shapes. For example, as illustrated in FIG. 2, external shapes of the first touch electrode 151 and the second touch electrode 152 may have a mesh pattern including a plurality of rhombic shapes. The first touch electrode 151 and the second touch electrode 152 may be formed of a metal including at least any one of titanium (Ti), aluminum (Al), molybdenum (Mo), molybdenum-titanium (MoTi), copper (Cu), and tantalum (Ta), and may be formed of a transparent conductive material such as indium tin oxide (ITO) and indium zinc oxide (IZO), but are not limited thereto. Light emitted from the display device 100 may pass through the first touch electrode 151 and the second touch electrode 152 made of a transparent conductive material and be emitted to the outside. However, the present disclosure is not limited thereto, and light emitted from the display device 100 may be emitted to the outside through a plurality of openings included in the first touch electrode 151 and the second touch electrode 152.

The non-display area N/A is an area surrounding the display area A/A, and a plurality of touch routing lines 155 and a plurality of touch pads TPAD are disposed in the non-display area N/A.

Each of the plurality of touch routing lines 155 electrically connects each of the plurality of touch electrodes 151 and 152 disposed in the display area A/A and the touch pad TPAD in the non-display area N/A. For example, a touch driving signal may be applied to the first touch electrode 151 through the touch routing line 155 connected to the first touch electrode 151 and a touch sensing signal may be transmitted to the second touch electrode 152 through the touch routing line 155 connected to the second touch electrode 152.

The touch routing line 155 may be made of a low-resistance metal material, or may be made of a transparent conductive material such as ITO or IZO, but is not limited thereto. For example, when the plurality of touch routing lines 155 is made of a low-resistance metal material, the resistance is lowered and the RC delay may be lowered.

One end of the plurality of touch pads TPAD is connected to the touch routing line 155 and the other end thereof is electrically connected to an external circuit such as a touch driver to receive a touch signal from the external circuit or transmit a touch sensing signal to the external circuit.

In this case, the plurality of touch routing lines 155 and the plurality of touch pads TPAD are disposed in an area corresponding to the non-display area N/A of the display device 100. In particular, the plurality of touch pads TPAD may be connected to the pads PAD disposed in the non-display area N/A.

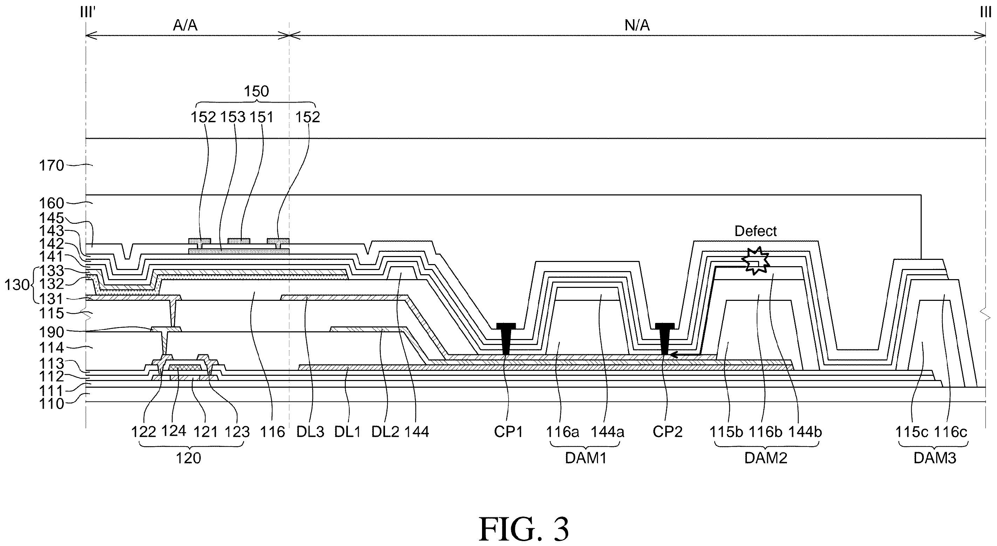

Hereinafter, a cross-sectional structure of the display area A/A of the display device 100 will be described in more detail with reference to FIG. 3.

FIG. 3 is a cross-sectional view of the display device 100 taken along the line III-III' of FIG. 1.

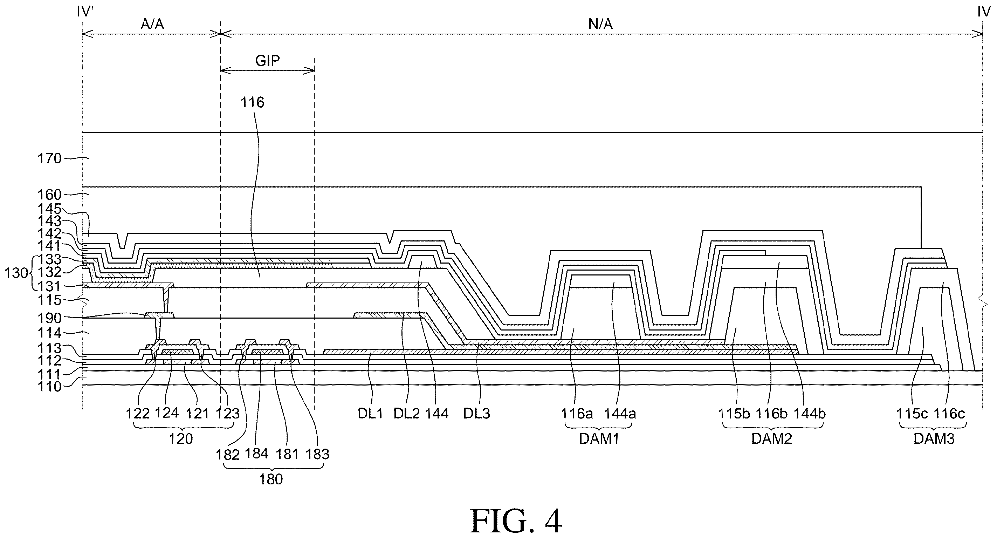

FIG. 4 is a cross-sectional view of the display device 100 taken along line IV-IV' illustrated in FIG. 1.

Referring to FIG. 3, a display area A/A of a display device according to one or more embodiments of the present disclosure may include a substrate 110, a buffer layer 111, a first driving transistor 120, a gate insulating layer 112, an interlayer insulating layer 113, a first planarization layer 114, an intermediate electrode 190, a second planarization layer 115, a bank 116, a light emitting element 130, an organic optical layer 141, an encapsulation layer 142, a touch buffer layer 143, a touch insulating layer 145, a touch sensing unit 150, a cover layer 160, and a filling layer 170.

The substrate 110 may support various components of the display device 100. The substrate 110 may be made of glass or a plastic material having flexibility. When the substrate 110 is made of a plastic material, for example, it may be made of polyimide (PI).

The buffer layer 111 may be disposed on the substrate 110. The buffer layer 111 may be formed by a single layer of silicon nitride (SiNx) or silicon oxide (SiOx) or a multi-layer thereof. The buffer layer 111 may serve to improve adhesion between layers formed on the buffer layer 111 and the substrate 110 and block alkali components, etc. flowing out of the substrate 110.

The driving transistor 120 may be disposed on the buffer layer 111. The driving transistor 120 may include an active layer 121, a gate electrode 124, a source electrode 122, and a drain electrode 123. Here, depending on the design of the pixel circuit, the source electrode 122 may be a drain electrode, and the drain electrode 123 may be a source electrode. The active layer 121 of the driving transistor 120 may be disposed on the buffer layer 111.

The active layer 121 may be formed of various materials such as polysilicon, amorphous silicon, or oxide semiconductor. The active layer 121 may include a channel region in which a channel is formed when the driving transistor 120 is driven, and a source region and a drain region on both sides of the channel region. The source region refers to a portion of the active layer 121 connected to the source electrode 122, and the drain region refers to a portion of the active layer 121 connected to the drain electrode 123.

The gate insulating layer 112 may be disposed on the active layer 121 of the driving transistor 120. The gate insulating layer 112 may be configured by a single layer of silicon nitride (SiNx) or silicon oxide (SiOx) or a multi-layer thereof. In the gate insulating layer 112, a contact hole through which the source electrode 122 and the drain electrode 123 of the driving transistor 120 are connected to the source region and the drain region of the active layer 121 of the driving transistor 120, respectively, may be formed.

The gate electrode 124 of the driving transistor 120 may be disposed on the gate insulating layer 112. The gate electrode 124 may be formed of a single layer or a multi-layer formed of any one of molybdenum (Mo), copper (Cu), titanium (Ti), aluminum (Al), chromium (Cr), gold (Au), nickel (Ni), and neodymium (Nd) or an alloy thereof. The gate electrode 124 may be formed on the gate insulating layer 112 so as to overlap the channel region of the active layer 121 of the driving transistor 120.

The interlayer insulating layer 113 may be disposed on the gate insulating layer 112 and the gate electrode 124. The interlayer insulating layer 113 may be configured by a single layer of silicon nitride (SiNx) or silicon oxide (SiOx) or a multi-layer thereof. A contact hole for exposing the source region and the drain region of the active layer 121 of the driving transistor 120 may be formed in the interlayer insulating layer 113. The source electrode 122 and the drain electrode 123 of the driving transistor 120 may be disposed on the interlayer insulating layer 113.

The source electrode 122 and the drain electrode 123 of the driving transistor 120 may be connected to the active layer 121 of the driving transistor 120 through contact holes formed in the gate insulating layer 112 and the interlayer insulating layer 113. Accordingly, the source electrode 122 of the driving transistor 120 may be connected to the source region of the active layer 121 through the contact holes formed in the gate insulating layer 112 and the interlayer insulating layer 113. Further, the drain electrode 123 of the driving transistor 120 may be connected to the drain region of the active layer 121 through the contact holes formed in the gate insulating layer 112 and the interlayer insulating layer 113.

The source electrode 122 and the drain electrode 123 of the driving transistor 120 may be formed by the same process. Further, the source electrode 122 and the drain electrode 123 of the driving transistor 120 may be formed of the same material. The source electrode 122 and the drain electrode 123 of the driving transistor 120 may be formed of a single layer or a multi-layer formed of any one of molybdenum (Mo), copper (Cu), titanium (Ti), aluminum (Al), chromium (Cr), gold (Au), nickel (Ni), and neodymium (Nd) or an alloy thereof.

The first planarization layer 114 may be disposed on the source electrode 122 and the drain electrode 123. As illustrated in FIG. 3, a contact hole for exposing the drain electrode 123 may be formed in the first planarization layer 114. The first planarization layer 114 may be an organic material layer for planarizing an upper portion of the driving transistor 120. For example, the first planarization layer 114 may be formed of an organic material such as acryl resin, epoxy resin, phenolic resin, polyamide resin, or polyimide resin. However, the present disclosure is not limited thereto, and the first planarization layer 114 may be an inorganic material layer for protecting the driving transistor 120. For example, the inorganic material may be silicon nitride (SiNx) or silicon oxide (SiOx). The first planarization layer 114 may be configured by a single layer of silicon nitride (SiNx) or silicon oxide (SiOx) or a multi-layer thereof.

The intermediate electrode 190 may be disposed on the first planarization layer 114. Further, the intermediate electrode 190 may be connected to the source electrode 122 of the driving transistor 120 through the contact hole of the first planarization layer 114. The intermediate electrode 190 may serve to electrically connect the driving transistor 120 and the light emitting element 130. For example, the intermediate electrode 190 may serve to electrically connect the source electrode 122 of the driving transistor 120 and the first electrode 131 of the light emitting element 130. The intermediate electrode 190 may be formed of a single layer or a multi-layer formed of any one of molybdenum (Mo), copper (Cu), titanium (Ti), aluminum (Al), chromium (Cr), gold (Au), nickel (Ni), and neodymium (Nd) or an alloy thereof. The intermediate electrode 190 may be formed of the same material as the source electrode 122 and the drain electrode 123 of the driving transistor 120.

The second planarization layer 115 may be disposed on the intermediate electrode 190 and the first planarization layer 114. Further, as illustrated in FIG. 3, a contact hole for exposing the intermediate electrode 190 may be formed in the second planarization layer 115. The second planarization layer 115 may be an organic material layer for planarizing an upper portion of the driving transistor 120. For example, the second planarization layer 115 may be formed of an organic material such as acryl resin, epoxy resin, phenolic resin, polyamide resin, or polyimide resin.

The light emitting element 130 may be disposed on the second planarization layer 115. The light emitting element 130 may include a first electrode 131, a light emitting structure 132, and a second electrode 133. The first electrode 131 of the light emitting element 130 may be disposed on the second planarization layer 115. The first electrode 131 may be electrically connected to the intermediate electrode 190 through a contact hole formed in the second planarization layer 115. Accordingly, the first electrode 131 of the light emitting element 130 is connected to the intermediate electrode 190 through the contact hole formed in the second planarization layer 115 to be electrically connected to the driving transistor 120.

The first electrode 131 may have a multi-layered structure including a transparent conductive film and an opaque conductive film having high reflection efficiency. The transparent conductive film may be made of a material having a relatively high work function value, such as indium-tin-oxide (ITO) or indium-zinc-oxide (IZO). Further, the opaque conductive film may have a single layer or multilayer structure including Al, Ag, Cu, Pb, Mo, Ti, or an alloy thereof. For example, the first electrode 131 may be formed in a structure in which a transparent conductive film, an opaque conductive film, and a transparent conductive film are sequentially stacked. However, the present disclosure is not limited thereto, and may be formed in a structure in which a transparent conductive film and an opaque conductive film are sequentially stacked.

Since the display device 100 according to one or more embodiments of the present disclosure is a top emission display device, the first electrode 131 may be an anode electrode. When the display device 100 is a bottom emission, the first electrode 131 disposed on the second planarization layer 115 may be a cathode electrode.

A bank 116 may be disposed on the first electrode 131 and the second planarization layer 115. An opening may be formed in the bank 116 to expose the first electrode 131. Since the bank 116 may define an emission area of the display device 100, it may also be referred to as a pixel defining layer.

The light emitting structure 132 including a light emitting layer may be disposed on the first electrode 131.

The light emitting structure 132 of the light emitting element 130 may be formed by laminating a hole layer, a light emitting layer, and an electron layer on the first electrode 131 in this order or in a reverse order. In addition, the light emitting structure 132 may include first and second light emitting structures facing each other with a charge generation layer interposed therebetween. In this case, any one light-emitting layer of the first and second light-emitting structures may generate blue light, and the other light-emitting layer of the first and second light-emitting structures may generate white light through the first and second light-emitting structures by generating yellow-green light. The white light generated by the light emitting structure 132 is incident on a color filter located above the light emitting structure 132 to implement a color image. In addition, color images may be implemented by generating color light corresponding to each sub-pixel in each light emitting structure 132 without a separate color filter. For example, the light emitting structure 132 of the red (R) sub-pixel may generate red light, the light emitting structure 132 of the green (G) sub-pixel may generate green light, and the light emitting structure 132 of the blue (B) sub-pixel may generate blue light.

A second electrode 133 may be further disposed on the light emitting structure 132. The second electrode 133 of the light emitting element 130 may be disposed on the light emitting structure 132 so as to face the first electrode 131 with the light emitting structure 132 interposed therebetween. In the display device 100 according to one or more embodiments of the present disclosure, the second electrode 133 may be a cathode electrode.

The organic optical layer 141 may be disposed on the light emitting element 130. The organic optical layer 141 may be formed of an organic material such as polyimide or polycarbonate. The organic optical layer 141 is excellent in transparency and thermal stability, and may reduce or minimize interfacial defects with the OLED device to achieve efficient optical efficiency.

An encapsulation layer 142 that suppresses moisture penetration may be further disposed on the organic optical layer 141. The encapsulation layer 142 may include a first inorganic encapsulation layer, an organic encapsulation layer, and a second inorganic encapsulation layer. The first inorganic encapsulation layer of the encapsulation layer 142 may be disposed on the second electrode 133. Further, the organic encapsulation layer may be disposed on the first inorganic encapsulation layer. Further, the second inorganic encapsulation layer may be disposed on the organic encapsulation layer. The first inorganic encapsulation layer and the second inorganic encapsulation layer of the encapsulation layer 142 may be formed of an inorganic material such as silicon nitride (SiNx) or silicon oxide (SiOx). The organic encapsulation layer of the encapsulation layer 142 may be formed of an organic material such as acryl resin, epoxy resin, phenolic resin, polyamide resin, or polyimide resin.

The second inorganic encapsulation layer may cover an upper surface and a side surface of each of the first inorganic encapsulation layer and the organic encapsulation layer, and the second inorganic encapsulation layer reduces, minimizes or blocks the permeation of external moisture or oxygen into the first inorganic encapsulation layer and the organic encapsulation layer. At this time, the first inorganic encapsulation layer and the second inorganic encapsulation layer serve to block or reduce the penetration of moisture or oxygen, and the organic encapsulation layer serves to planarize the upper portion of the first inorganic encapsulation layer. Therefore, the encapsulation layer 142 may cover the gate driving circuit GIP and the dam in the display area A/A and the non-display area N/A. However, the configuration of the encapsulation layer 142 is not limited thereto.

The touch buffer layer 143 may be disposed on the encapsulation layer 142. The touch buffer layer 143 may be formed by a single layer of silicon nitride (SiNx) or silicon oxide (SiOx) or a multi-layer thereof. The touch buffer layer 143 may improve an adhesive force of the touch sensing unit 150 formed on the touch buffer layer 143.

The touch sensing unit 150 may be disposed on the touch buffer layer 143. The touch sensing unit 150 may include touch electrodes 151 and 152 and a touch connection electrode 153.

The touch connection electrode 153 of the touch sensing unit 150 may be disposed on the touch buffer layer 143. The touch connection electrode 153 is disposed at a point where the touch electrodes 151 and 152 arranged in different directions intersect and is used to connect the touch electrodes 151 and 152 arranged in any one direction. The touch connection electrode 153 may be formed of a transparent conductive layer, and for example, may be formed of a transparent conductive oxide such as ITO or IZO.

The touch insulating layer 145 may be disposed on the touch buffer layer 143 and the touch connection electrode 153. The touch insulating layer 145 may insulate between the touch connection electrode 153 and the touch electrodes 151 and 152. Further, the touch insulating layer 145 may be formed of an inorganic material layer or an organic material layer. When the touch insulating layer 145 is an inorganic material layer, the touch insulating layer 145 may be configured by a single layer of silicon nitride (SiNx) or silicon oxide (SiOx) or a multi-layer thereof. Further, when the touch insulating layer 145 is an organic material layer, the touch insulating layer 145 may be formed of an organic material such as acryl resin, epoxy resin, phenolic resin, polyamide resin, or polyimide resin. A contact hole for exposing the touch connection electrode 153 may be formed in the touch insulating layer145.

A plurality of first touch electrodes 151 and a plurality of second touch electrodes 152 of the touch sensing unit 150 may be disposed on the touch insulating layer 145. The plurality of second touch electrodes 152 may be connected to the touch connection electrode 153 through a contact hole of the touch insulating layer145. The plurality of second touch electrodes 152 may be connected to each other by the touch connection electrode 153.

The first touch electrode 151 and the second touch electrode 152 of the touch sensing unit 150 may be formed of a transparent conductive film such as indium-tin-oxide (ITO) or indium-zinc-oxide (IZO). However, the present disclosure is not limited thereto, and the first touch electrode 151 and the second touch electrode 152 may be formed of an opaque conductive film having an opening. When the first touch electrode 151 and the second touch electrode 152 are formed of an opaque conductive film having an opening, the first touch electrode 151 and the second touch electrode 152 may be formed of a single layer or a multi-layer formed of any one of molybdenum (Mo), copper (Cu), titanium (Ti), aluminum (Al), chromium (Cr), gold (Au), nickel (Ni), and neodymium (Nd) or an alloy thereof.

The cover layer 160 may be disposed on the touch sensing unit 150 and the touch insulating layer 145. The cover layer 160 may planarize the touch sensing unit 150 and the touch insulating layer 145. Further, the cover layer 160 is made of a polymer material such as polyimide or epoxy, an inorganic material such as silicon oxide (SiO2) or aluminum oxide (Al2O3), or an organic-inorganic composite material. These materials provide moisture and oxygen barrier, excellent adhesion, and high transparency, extend the stability and lifespan of the display device, and contribute to maintaining optical performance.

The filling layer 170 may be disposed on the cover layer 160. The filling layer 170 may be made of a high molecular weight material such as polyimide, polycarbonate, or acrylic resin, or a low molecular weight material such as polymethyl methacrylate (PMMA) and epoxy resin. Accordingly, the filling layer 170 is used to maintain interlayer uniformity or fill structural voids, and supports device stability and efficiency.

Referring to FIGS. 3 and 4, a gate driving circuit GIP, a plurality of lines DL1, DL2, and DL3, a spacer 144, a plurality of dams DAM1, DAM2, and DAM3, and a plurality of blocking patterns CP1 and CP2 may be disposed in the non-display area N/A of the display device 100.

The gate driving circuit GIP receives a gate control signal through the gate control lines and generates gate signals according to the gate control signal to sequentially output signals to the gate lines in the display area A/A. The gate driving circuit GIP may be disposed in the non-display area N/A of the substrate 110 in a gate in panel (GIP) manner. The gate driving circuit GIP may include a plurality of gate transistors 180 having the same interlayer relationship as the driving transistor 120 or the switching transistor disposed in the display area A/A.

That is, the gate transistor 180 may be disposed on the buffer layer 111 extending to the non-display area N/A. The gate transistor 180 may include an active layer 181, a gate electrode 184, a source electrode 182, and a drain electrode 183. Here, depending on the design of the pixel circuit, the source electrode 182 may be a drain electrode, and the drain electrode 183 may be a source electrode. The active layer 181 of the gate transistor 180 may be disposed on the buffer layer 111.

The active layer 181 may be formed of various materials such as polysilicon, amorphous silicon, or oxide semiconductor. The active layer 181 may include a channel region in which a channel is formed when the gate transistor 180 is driven, and a source region and a drain region on both sides of the channel region. The source region refers to a portion of the active layer 181 connected to the source electrode 182, and the drain region refers to a portion of the active layer 181 connected to the drain electrode 183.

A gate insulating layer 112 extending to the non-display area N/A may be disposed on the active layer 181 of the gate transistor 180. A contact hole through which the source electrode 182 and the drain electrode 183 of the gate transistor 180 are connected to the source region and the drain region of the active layer 181 of the gate transistor 180 may be formed in the gate insulating layer 112.

The gate electrode 184 of the gate transistor 180 may be disposed on the gate insulating layer 112. The gate electrode 184 may be formed on the gate insulating layer 112 so as to overlap the channel region of the active layer 181 of the gate transistor 180.

An interlayer insulating layer 113 extending to the non-display area N/A may be disposed on the gate insulating layer 112 and the gate electrode 184. A contact hole for exposing the source region and the drain region of the active layer 181 of the gate transistor 180 may be formed in the interlayer insulating layer 113. The source electrode 182 and the drain electrode 183 of the gate transistor 180 may be disposed on the interlayer insulating layer 113.

The source electrode 182 and the drain electrode 183 of the gate transistor 180 may be connected to the active layer 181 of the gate transistor 180 through contact holes formed in the gate insulating layer 112 and the interlayer insulating layer 113. Accordingly, the source electrode 182 of the gate transistor 180 may be connected to the source region of the active layer 181 through the contact holes formed in the gate insulating layer 112 and the interlayer insulating layer 113. Further, the drain electrode 183 of the gate transistor 180 may be connected to the drain region of the active layer 181 through contact holes formed in the gate insulating layer 112 and the interlayer insulating layer 113. The first planarization layer 114 extending to the non-display area N/A may be disposed on the source electrode 182 and the drain electrode 183.

The first line DL1 may be disposed on the interlayer insulating layer 113 extending to the non-display area N/A. The first line DL1 may be formed of the same material as the source electrode 122 and the drain electrode 123 of the driving transistor 120. That is, the first line DL1 may be formed by the same process as the source electrode 122 and the drain electrode 123 of the driving transistor 120. Therefore, the first line DL1 may be formed of a single layer or a multi-layer formed of any one of molybdenum (Mo), copper (Cu), titanium (Ti), aluminum (Al), chromium (Cr), gold (Au), nickel (Ni), and neodymium (Nd) or an alloy thereof.

Further, the first planarization layer 114 extending to the non-display area N/A may be disposed on the first line DL1, and the second line DL2 may be disposed on the first planarization layer 114. The second line DL2 may be formed of the same material as the intermediate electrode 190. That is, the second line DL2 may be formed by the same process as the intermediate electrode 190. Therefore, the second line DL2 may be formed of a single layer or a multi-layer formed of any one of molybdenum (Mo), copper (Cu), titanium (Ti), aluminum (Al), chromium (Cr), gold (Au), nickel (Ni), and neodymium (Nd) or an alloy thereof.

Further, the second planarization layer 115 extending to the non-display area N/A may be disposed on the second line DL2, and the third line DL3 may be disposed on the second planarization layer 115. The third line DL3 may be formed of the same material as the first electrode 131. That is, the third line DL3 may be formed by the same process as the intermediate electrode 190. Accordingly, the third line DL3 may be formed in a multilayer structure including a transparent conductive film and an opaque conductive film having high reflection efficiency. The transparent conductive film may be made of a material having a relatively high work function value, such as indium-tin-oxide (ITO) or indium-zinc-oxide (IZO). Further, the opaque conductive film may have a single layer or multilayer structure including Al, Ag, Cu, Pb, Mo, Ti, or an alloy thereof.

Further, the plurality of lines DL1, DL2, and DL3 may be in contact with each other in a partial area of the non-display area N/A. For example, in FIG. 4, the interlayer insulating layer 113, the first planarization layer 114, and the second planarization layer 115 may not be disposed outside the gate driving circuit GIP so that the plurality of lines DL1, DL2, and DL3 may be in contact with each other to be electrically connected. Therefore, the same voltage may be applied to the plurality of lines DL1, DL2, and DL3, and stability of the applied voltage may be improved.

Further, a spacer 144 may be disposed on the bank 116 extending to the non-display area N/A to be spaced apart from the light emitting element 130. The spacer 144 maintains an appropriate gap in the display device to ensure mechanical stability, and distributes external pressure to reduce or prevent device damage and substrate deformation. In addition, the spacer 144 maintains a uniform thickness and spacing of the light emitting structure 132 to improve optical performance and image quality. As the material of the spacer 144, a polymer material such as polyimide or epoxy, and an inorganic material such as silica are used, and optical performance is maintained through transparent properties.

The dam DAM may be disposed on the non-display area N/A. The dam DAM is disposed to control the spread of the organic encapsulation layer which forms the encapsulation layer 142 disposed in the display area A/A and the non-display area N/A of the substrate 110. The plurality of dams DAM1, DAM2, and DAM3 may include a first dam DAM1, a second dam DAM2, and a third dam DAM3. The first dam DAM1 may surround the non-display area N/A adjacent to the display area A/A, the second dam DAM2 may surround an outer periphery of the first dam DAM, and the third dam DAM3 may surround an outer periphery of the second dam DAM2.

Each of the plurality of dams DAM1, DAM2, and DAM3 may be formed as a multi-layer. Specifically, the first dam DAM1 may include a first layer 116a of the first dam DAM1 disposed on the third line DL3 and a second layer 144a of the first dam DAM1. The first layer 116a of the first dam DAM1 may be formed of the same material as the bank 116, and the second layer 144a of the first dam DAM1 may be formed of the same material as the spacer 144.

Further, the second dam DAM2 may include a first layer 115b of the second dam DAM2 disposed on the second line DL2, a second layer 116b of the second dam DAM2, and a third layer 144b of the second dam DAM2. The first layer 115b of the second dam DAM2 may be formed on the same layer as the second planarization layer 115, the second layer 116b of the second dam DAM2 may be formed of the same material as the bank 116, and the third layer 144b of the second dam DAM2 may be formed of the same material as the spacer 144.

Further, at least one of the organic optical layer 141, the encapsulation layer 142, the touch buffer layer 143, and the touch insulating layer 145 may be disposed to cover at least one of the plurality of dams DAM1, DAM2, and DAM3.

Specifically, the organic optical layer 141 may be formed to cover the first dam DAM1 and the second dam DAM2, and the remaining encapsulation layer 142, the touch buffer layer 143, and the touch insulating layer 145 may be formed to cover all the plurality of dams DAM1, DAM2, and DAM3.

Further, the plurality of blocking patterns CP1 and CP2 are disposed in the non-display area N/A of the display device 100 in stages to protect the display device from moisture and the external environment. The first blocking pattern CP1 is disposed between the display area A/A and the first dam DAM1, and the second blocking pattern CP2 is disposed between the first dam DAM1 and the second dam DAM2. The blocking patterns CP1 and CP2 are disposed to penetrate the organic optical layer 141, the encapsulation layer 142, the touch buffer layer 143, and the touch insulating layer 145.

Further, the blocking patterns CP1 and CP2 may be formed of the same material as the touch electrodes 151 and 152 and the touch connection electrode 153. Therefore, the blocking patterns CP1 and CP2 may be formed of a transparent conductive material such as indium-tin-oxide (ITO) or indium-zinc-oxide (IZO) or a metal material such as molybdenum (Mo), copper (Cu), titanium (Ti), and aluminum (Al). Accordingly, the blocking patterns CP1 and CP2 have transparency and conductivity, and provide moisture blocking and electrical stability.

Further, a width of a first surface (i.e., top surface) of at least one of the blocking patterns CP1 and CP2 is greater than a width of a second surface (i.e., bottom surface) of at least one of the blocking patterns CP1 and CP2 in a cross-sectional view of the display device 100, wherein the first surface is further from the substrate 110 than the second surface in the cross-sectional view.

Meanwhile, the organic optical layer 141 of the present disclosure is a layer used to protect the light emitting element 130 of the display device 100 and maintain optical efficiency, and is made of a material excellent in transparency and thermal stability. However, foreign substances may be mixed into the organic optical layer 141 during the manufacturing process, or fine defects (e.g., pinholes, cracks, etc.) may occur due to external environmental factors. These defects form a moisture penetration path, allowing external moisture and oxygen to penetrate into the interior. Foreign matters or defects generated in the organic optical layer 141 weaken the protection function of the encapsulation layer 142 and allow moisture and oxygen to penetrate into the light emitting element 130 and the driving transistor 120, which are internal components of the display device. This may cause a decrease in the performance of the device, such as a decrease in the lifespan of the light emitting element 130, a decrease in luminous efficiency, and a defect in pixels. In particular, when the organic material and moisture inside the light emitting element 130 react, the electrical characteristics deteriorate, resulting in a phenomenon in which the luminous efficiency rapidly decreases.

Accordingly, the plurality of blocking patterns CP1 and CP2 of the display device 100 according to one or more embodiments of the present disclosure are disposed in the organic optical layer 141 and the encapsulation layer 142 to effectively block the moisture penetration path. The blocking patterns CP1 and CP2 physically block the moisture penetration path formed by the defect generated in the organic optical layer 141 or block the moisture before reaching the light emitting element 130 by significantly reducing the rate at which moisture diffuses into the inside. The first blocking pattern CP1 is disposed between the display area A/A and the first dam DAM1 to serve as a primary defense line, and the second blocking pattern CP2 is disposed between the first dam DAM1 and the second dam DAM2 to serve as a secondary defense line. Such a stepwise blocking structure divides the moisture penetration path generated in the organic optical layer 141 into several compartments and gradually blocks moisture from diffusing into the interior.

Further, the blocking patterns CP1 and CP2 cooperate with the organic and inorganic layers of the encapsulation layer 142 to reduce or minimize the moisture permeation due to the defect generated in the organic optical layer 141. The inorganic encapsulation layer acts as a physical blocking, and the blocking pattern divides the moisture penetration path in detail to help moisture dissipate before penetrating the encapsulation layer. With this function, the blocking patterns CP1 and CP2 serve to protect the internal components by localizing the effect of foreign matter and defects occurring in the organic optical layer 141 on the entire display device, and to increase the reliability and durability of the display device. As a result, the blocking pattern plays a key role in maintaining long-term stability and performance of the display device.

In addition, the plurality of blocking patterns CP1 and CP2 of the display device according to one or more embodiments of the present disclosure serve to reduce or prevent the penetration of moisture and oxygen in the display device 100 and are electrically connected to the plurality of lines DL1, DL2, and DL3 to provide an important technical effect of promoting voltage stability.

Specifically, the electrical connection between the plurality of lines DL1, DL2, and DL3 and the blocking patterns CP1 and CP2 maintains a uniform voltage throughout the display device 100, thereby reducing or preventing the performance degradation of the driving transistor 120 and the light emitting element 130. In particular, voltage uniformity is secured by minimizing or at least reducing signal delay or distortion that may occur when an electrical signal is transmitted through a long or complex line. Further, the blocking patterns CP1 and CP2 disperse or shield noise through the lines DL1, DL2, and DL3 to suppress the external electromagnetic interference EMI, increase the electrical stability of the display device 100, and reduce or prevent deterioration in image quality.

In addition, the blocking patterns CP1 and CP2 absorb or disperse voltage spikes or overvoltages that may occur around the gate driving circuit GIP and the light emitting element 130 to reduce or prevent device damage and improve durability. This reduces or minimizes power loss between the light emitting element 130 and the driving transistor 120 and contributes to increasing power efficiency of the display device 100 by reducing overall power consumption. This securing of electrical stability optimizes the driving environment of the light emitting element 130, maintains uniform luminous efficiency and high image quality, and consequently extends the device life and provides a stable screen.

In conclusion, the blocking patterns CP1 and CP2 serve as key elements to significantly improve the performance and reliability of the display device 100 by reducing or preventing moisture permeation as well as promoting electrical stability. This plays an important role in optimizing the driving environment of the device and providing a high-quality screen to the user.

Hereinafter, a display device according to one or more other embodiments of the present disclosure will be described. Since the display device according to one or more embodiments of the present disclosure and the display device according to one or more other embodiments of the present disclosure differ only in the arrangement relationship of the organic optical layer, this will only be described.

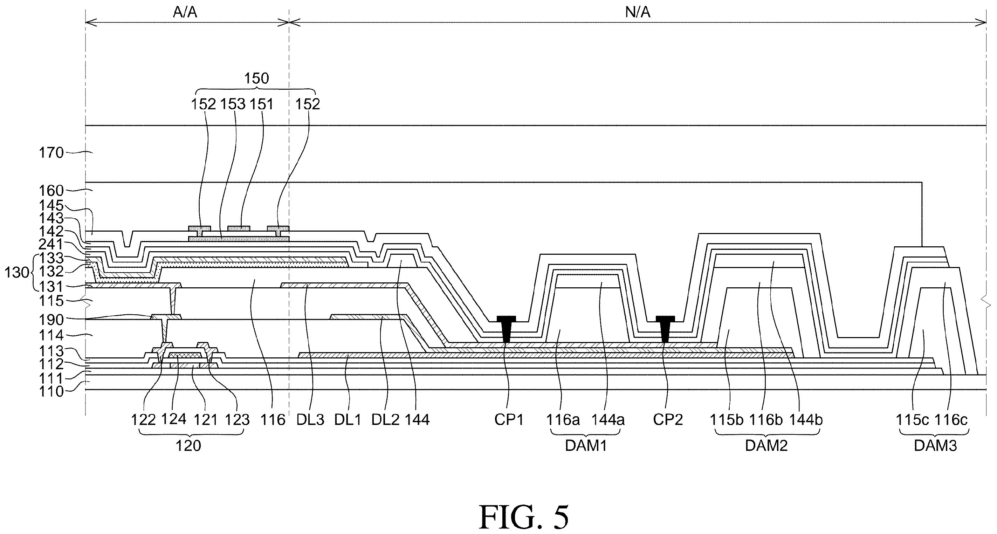

FIG. 5 is a cross-sectional view of a display device according to one or more other embodiments of the present disclosure.

Referring to FIG. 5, the organic optical layer 241 is disposed to extend to the display area A/A and the non-display area N/A of the display device, but extends only before the spacer 144 in the non-display area N/A. This is different from the above embodiment of the present disclosure in that the organic optical layer 241 is designed not to cover the plurality of dams DAM1, DAM2, and DAM3.

In one or more other embodiments of the present disclosure, the reason why the organic optical layer 241 is disposed so as to extend only before the spacer 144 is to optimize the structural design. Since the organic optical layer 241 does not cover the dams DAM1, DAM2, and DAM3, moisture permeation prevention and stability of the encapsulation layer 142 may be maintained independently of the dams DAM1, DAM2, and DAM3. In addition, this design has the advantage of improving the efficiency of the manufacturing process by reducing the amount of material used in the organic optical layer 241.

In addition, by reducing or preventing interference between the organic optical layer 241 and the dams DAM1, DAM2, and DAM3, it does not impair the effect of controlling the spread of the encapsulation layer 142 and blocking moisture, which are the main functions of the dam. The organic optical layer 241 serves to improve and protect the performance of the light emitting element 130, and the dams DAM1, DAM2, and DAM3 independently perform the functions of forming the boundary of the encapsulation layer 142 and reducing or preventing moisture permeation.

Therefore, the design in which the organic optical layer 241 is disposed to extend only before the spacer 144 may optimize the independent function of each component and contribute to increase the structural stability of the display device and the efficiency of the manufacturing process.

The embodiments of the present disclosure can also be described as follows:
A display device according to one or more embodiments of the present disclosure may include a substrate including a display area and a non-display area surrounding the display area, a plurality of pixels disposed in the display area and including a light emitting element and a driving transistor, at least one dam disposed in the non-display area, an organic optical layer covering the plurality of pixels, and at least one blocking pattern disposed in the non-display area and penetrating the organic optical layer.

According to another feature of the present disclosure, the at least one blocking pattern may be disposed in at least one of an area between the display area and the at least one dam and an area between the at least one dam.

According to another feature of the present disclosure, at least one dam disposed in the non-display area is a first dam Also, a second dam disposed outside the first dam may be included, and the at least one blocking pattern may include a first blocking pattern disposed between the display area and the first dam and a second blocking pattern disposed between the first dam and the second dam.

According to another feature of the present disclosure, at least one gate driving circuit disposed in the non-display area may be further included, and the at least one blocking pattern may not be disposed outside the at least one gate driving circuit.

According to another feature of the present disclosure, an encapsulation layer disposed on the organic optical layer to encapsulate the light emitting element may be further included, and the at least one blocking pattern may penetrate the encapsulation layer.

According to another feature of the present disclosure, the display device may further include a touch buffer layer disposed on the encapsulation layer and a touch sensing unit disposed on the touch buffer layer, the touch sensing unit may include a plurality of touch electrodes, a touch connection electrode connecting the plurality of touch electrodes, and a touch insulating layer insulating the plurality of touch electrodes and the touch connection electrode.

According to another feature of the present disclosure, the at least one blocking pattern may penetrate at least one of the touch buffer layer and the touch insulating layer.

According to another feature of the present disclosure, the at least one blocking pattern may be formed of the same material as any one of the plurality of touch electrodes and the touch connection electrode.

According to another feature of the present disclosure, the plurality of pixels may further include an intermediate electrode disposed between the driving transistor and the light emitting element to electrically connect the driving transistor and the light emitting element, and the non-display area may include a first line formed of the same material as the source electrode and the drain electrode of the driving transistor, a second line formed of the same material as the intermediate electrode, and a third line formed of the same material as the anode electrode of the light emitting element.

According to another feature of the present disclosure, the at least one blocking pattern may be electrically connected to the first line, the second line, and the third line.

According to another feature of the present disclosure, the organic optical layer may extend to the non-display area to cover the at least one dam.

The following numbered examples pertain to embodiments of the present disclosure.

Example 1: A display device, comprising: a substrate including a display area and a non-display area surrounding the display area; a plurality of pixels disposed in the display area, a pixel of the plurality of pixels including a light emitting element and a driving transistor; at least one dam disposed in the non-display area; an organic optical layer covering the plurality of pixels; and at least one blocking pattern disposed in the non-display area and penetrating the organic optical layer.

Example 2: The display device according to Example 1, wherein the at least one blocking pattern is disposed in at least one of an area between the display area and a first dam of the at least one dam and an area between the first dam and a second dam of the at least one dam.

Example 3: The display device according to Example 1 or 2, wherein the at least one dam disposed in the non-display area includes a first dam and a second dam disposed outside the first dam, and wherein the at least one blocking pattern comprises a first blocking pattern and a second blocking pattern, the first blocking pattern disposed between the display area and the first dam, and the second blocking pattern disposed between the first dam and the second dam.

Example 4: The display device according to any of Examples 1 to 3, further comprising: at least one gate driving circuit disposed in the non-display area, wherein the at least one blocking pattern is not disposed outside the at least one gate driving circuit.

Example 5: The display device according to any of Examples 1 to 4, further comprising: an encapsulation layer disposed on the organic optical layer to encapsulate the light emitting element, wherein the at least one blocking pattern passes through the encapsulation layer.

Example 6: The display device according to Example 5, further comprising: a touch buffer layer disposed on the encapsulation layer; and a touch sensing unit disposed on the touch buffer layer, wherein the touch sensing unit includes a plurality of touch electrodes, a touch connection electrode connecting the plurality of touch electrodes, and a touch insulating layer insulating the plurality of touch electrodes and the touch connection electrode.

Example 7: The display device according to Example 6, wherein the at least one blocking pattern passes through at least one of the touch buffer layer and the touch insulating layer.

Example 8: The display device according to Example 6 or 7, wherein the at least one blocking pattern includes a same material as any one of the plurality of touch electrodes and the touch connection electrode.

Example 9: The display device according to any of Examples 1 to 8, wherein the pixel further comprises an intermediate electrode disposed between the driving transistor and the light emitting element to electrically connect the driving transistor and the light emitting element, wherein in the non-display area: a first line comprises a same material as a source electrode of the driving transistor and a drain electrode of the driving transistor; a second line comprises a same material as the intermediate electrode; and a third line comprises a same material as an anode electrode of the light emitting element.

Example 10: The display device according to Example 9, wherein the at least one blocking pattern is electrically connected to the first line, the second line, and the third line.

Example 11: The display device according to any of Examples 1 to 10, wherein the organic optical layer extends to the non-display area to cover the at least one dam.

Example 12: A display device, comprising: a substrate including a display area and a non-display area surrounding the display area; a plurality of pixels disposed in the display area, a pixel of the plurality of pixels including a light emitting element; a data line disposed in the non-display area and including a metal material, the data line supplying a voltage to the pixel; at least one dam disposed in the non-display area; and at least one blocking pattern disposed in the non-display area and including a conductive material, wherein the at least one blocking pattern is directly connected to the data line.

Example 13: The display device according to Example 12, further comprising: an organic optical layer covering the plurality of pixels and extending to the non-display area; and an encapsulation layer disposed on the organic optical layer and extending to the non-display area, wherein the at least one blocking pattern penetrates through the encapsulation layer and organic optical layer to be in direct contact with the data line.

Example 14: The display device according to Example 13, further comprising: a touch buffer layer disposed on the encapsulation layer; and a touch sensing unit disposed in the display area on the touch buffer layer, the touch sensing unit including a touch insulating layer extending to the non-display area, wherein the at least one blocking pattern further penetrates through the touch insulating layer and the touch buffer layer.

Example 15: The display device according to Example 12, further comprising: an organic optical layer covering the plurality of pixels and extending to the non-display area; and an encapsulation layer disposed on the organic optical layer in the display area, the encapsulation layer extending to the non-display area and disposed on a portion of the organic optical layer in the non-display area, wherein the at least one blocking pattern penetrates through the encapsulation layer to be in direct contact with the data line.

Example 16: The display device according to Example 15, further comprising: a spacer disposed in the non-display area between the display area and the at least one blocking pattern, wherein the organic optical layer extends to a portion of the non-display area between the display area and the spacer, and wherein the organic optical layer does not extend to another portion of the non-display area between the spacer and the at least one blocking pattern.

Example 17: The display device according to any of Examples 12 to 16, wherein the at least one blocking pattern extends in a plan view of the display device from a first side of the display device to a second side of the display device opposite to the first side, and wherein a length of the at least one blocking pattern is greater than a width of the display area in the plan view.

Example 18: The display device according to any of Examples 12 to 17, wherein a width of a first surface of the at least one blocking pattern is greater than a width of a second surface of the at least one blocking pattern in a cross-sectional view of the display device, and wherein the first surface is further from the substrate than the second surface in the cross-sectional view.

Example 19: The display device according to any of Examples 12 to 18, wherein the at least one blocking pattern is between the display area and the at least one dam.

Example 20: The display device according to any of Examples 12 to 19, wherein the at least one blocking pattern includes a first blocking pattern and a second blocking pattern, wherein the at least one dam includes a first dam and a second dam, wherein the first blocking pattern is between the display area and the first dam, and wherein the second blocking pattern is between the first dam and the second dam.

## Claims

1. A display device (100), comprising:
a substrate (110) including a display area (A/A) and a non-display area (N/A) surrounding the display area (A/A);
a plurality of pixels (PX) disposed in the display area (A/A), a pixel of the plurality of pixels (PX) including a light emitting element (130) and a driving transistor (120);
at least one dam (DAM1, DAM2, DAM3) disposed in the non-display area (N/A);
an organic optical layer (141, 241) covering the plurality of pixels (PX); and
at least one blocking pattern (CP1, CP2) disposed in the non-display area (N/A) and penetrating the organic optical layer (141, 241).

2. The display device (100) according to claim 1, wherein the at least one blocking pattern (CP1, CP2) is disposed in at least one of an area between the display area (A/A) and a first dam (DAM1) of the at least one dam (DAM1, DAM2, DAM3) and an area between the first dam (DAM1) and a second dam (DAM2) of the at least one dam (DAM1, DAM2, DAM3).

3. The display device (100) according to claim 1 or 2, wherein the at least one dam (DAM1, DAM2, DAM3) disposed in the non-display area (N/A) includes a first dam (DAM1) and a second dam (DAM2) disposed outside the first dam (DAM1), and
wherein the at least one blocking pattern (CP1, CP2) comprises a first blocking pattern (CP1) and a second blocking pattern (CP2), the first blocking pattern (CP1) disposed between the display area (A/A) and the first dam (DAM1), and the second blocking pattern (CP2) disposed between the first dam (DAM1) and the second dam (DAM2).

4. The display device (100) according to any of claims 1 to 3, further comprising:
at least one gate driving circuit (GIP) disposed in the non-display area (N/A),
wherein the at least one blocking pattern (CP1, CP2) is not disposed outside the at least one gate driving circuit (GIP).

5. The display device (100) according to any of claims 1 to 4, further comprising:
an encapsulation layer (142) disposed on the organic optical layer (141, 241) to encapsulate the light emitting element (130),
wherein the at least one blocking pattern (CP1, CP2) passes through the encapsulation layer (142).

6. The display device (100) according to claim 5, further comprising:
a touch buffer layer (143) disposed on the encapsulation layer (142); and
a touch sensing unit (150) disposed on the touch buffer layer (143),
wherein the touch sensing unit (150) includes a plurality of touch electrodes (151, 152), a touch connection electrode (153) connecting the plurality of touch electrodes (151, 152), and a touch insulating layer (145) insulating the plurality of touch electrodes (151, 152) and the touch connection electrode (153).

7. The display device (100) according to claim 6, wherein the at least one blocking pattern (CP1, CP2) passes through at least one of the touch buffer layer (143) and the touch insulating layer (145), and/or
wherein the at least one blocking pattern (CP1, CP2) includes a same material as any one of the plurality of touch electrodes (151, 152) and the touch connection electrode (153).

8. The display device (100) according to any of claims 1 to 7, wherein the pixel further comprises an intermediate electrode (190) disposed between the driving transistor (120) and the light emitting element (130) to electrically connect the driving transistor (120) and the light emitting element (130),
wherein in the non-display area (N/A):
a first line (DL1) comprises a same material as a source electrode of the driving transistor (120) and a drain electrode of the driving transistor (120);
a second line (DL2) comprises a same material as the intermediate electrode (190); and
a third line (DL3) comprises a same material as an anode electrode of the light emitting element (130).

9. The display device (100) according to claim 8, wherein the at least one blocking pattern (CP1, CP2) is electrically connected to the first line (DL1), the second line (DL2), and the third line (DL3).

10. The display device (100) according to any of claims 1 to 9, wherein the organic optical layer (141) extends to the non-display area (N/A) to cover the at least one dam (DAM1, DAM2, DAM3).

11. The display device (100) of claim 1, further comprising:
a data line disposed in the non-display area (N/A) and including a metal material, the data line supplying a voltage to the pixel;
wherein the at least one blocking pattern (CP1, CP2) includes a conductive material, and
wherein the at least one blocking pattern (CP1, CP2) is directly connected to the data line.

12. The display device (100) according to claim 11, further comprising:
an encapsulation layer (142) disposed on the organic optical layer (141, 241) and extending to the non-display area (N/A),
wherein the at least one blocking pattern (CP1, CP2) penetrates through the encapsulation layer (142) and organic optical layer (141, 241) to be in direct contact with the data line,
the display device (100), preferably, further comprising:
a touch buffer layer (143) disposed on the encapsulation layer (142); and
a touch sensing unit (150) disposed in the display area (A/A) on the touch buffer layer (143), the touch sensing unit (150) including a touch insulating layer (145) extending to the non-display area (N/A),
wherein the at least one blocking pattern (CP1, CP2) further penetrates through the touch insulating layer (145) and the touch buffer layer (143).

13. The display device (100) according to claim 11, further comprising:
an encapsulation layer (142) disposed on the organic optical layer (241) in the display area (A/A), the encapsulation layer (142) extending to the non-display area (N/A) and disposed on a portion of the organic optical layer (241) in the non-display area (N/A),
wherein the at least one blocking pattern (CP1, CP2) penetrates through the encapsulation layer (142) to be in direct contact with the data line,
the display device (100), preferably, further comprising:
a spacer (144) disposed in the non-display area (N/A) between the display area (A/A) and the at least one blocking pattern (CP1, CP2),
wherein the organic optical layer (241) extends to a portion of the non-display area (N/A) between the display area (A/A) and the spacer (144), and
wherein the organic optical layer (241) does not extend to another portion of the non-display area (N/A) between the spacer (241) and the at least one blocking pattern (CP1, CP2).

14. The display device (100) according to any of claims 11 to 13, wherein the at least one blocking pattern (CP1, CP2) extends in a plan view of the display device (100) from a first side of the display device (100) to a second side of the display device (100) opposite to the first side, and
wherein a length of the at least one blocking pattern (CP1, CP2) is greater than a width of the display area (A/A) in the plan view.

15. The display device (100) according to any of claims 11 to 14, wherein:
a width of a first surface of the at least one blocking pattern (CP1, CP2) is greater than a width of a second surface of the at least one blocking pattern (CP1, CP2) in a cross-sectional view of the display device (100), and wherein the first surface is further from the substrate (110) than the second surface in the cross-sectional view;
and/or wherein:
the at least one blocking pattern (CP1, CP) is between the display area (A/A) and the at least one dam (DAM1, DAM2, DAM3);
and/or wherein:
the at least one blocking pattern (CP1, CP2) includes a first blocking pattern (CP1) and a second blocking pattern (CP2),
the at least one dam (DAM1, DAM2, DAM3) includes a first dam (DAM1) and a second dam (DAM2),
the first blocking pattern (CP1) is between the display area (A/A) and the first dam (DAM1), and
the second blocking pattern (CP2) is between the first dam (DAM1) and the second dam (DAM2).
